# EUROPÄISCHE PATENTSCHRIFT

(11) **EP 3 017 462 B1**
(45) Veröffentlichungstag und Bekanntmachung des Hinweises auf die Patenterteilung: **13.09.2017**
(21) Anmeldenummer: 13734389.3
(22) Anmeldetag: 04.07.2013
(51) Int. Cl.: H01L 21/67, H01L 21/02, H01L 21/66

(54) **VERFAHREN UND VORRICHTUNG ZUR BEHANDLUNG EINER SUBSTRATOBERFLÄCHE**
METHOD AND DEVICE FOR TREATING A SUBSTRATE SURFACE
PROCÉDÉ ET DISPOSITIF PERMETTANT DE TRAITER LA SURFACE D'UN SUBSTRAT

(43) Veröffentlichungstag der Anmeldung: 11.05.2016
(73) Patentinhaber: EV Group E. Thallner GmbH, 4782 St. Florian am Inn (AT)
(72) Erfinder: SCHMIDBAUER, Martin, A-4761 Enzenkirchen (AT); ZENGER, Tobias, 94036 Passau (DE); SCHMID, Florian, A-4941 Mehrnbach (AT); WIESER, Thomas, 84375 Kirchdorf am Inn (DE); STELZHAMMER, Hermann, A-4754 Andrichsfurt (AT); TRACKSDORF, Martin, 4780 Schärding (AT)
(74) Vertreter: Schneider, Sascha
(86) Internationale Anmeldenummer: PCT/EP2013/064151
(87) Internationale Veröffentlichungsnummer: WO 2015/000520

(56) Entgegenhaltungen:
- US-A- 4 507 078
- US-A1- 2005 245 005
- US-A1- 2012 304 921

## Beschreibung

Die Erfindung betrifft ein Verfahren gemäß Anspruch 1 sowie eine Vorrichtung nach Anspruch 8.

In der Halbleiterindustrie werden unzählige Chemikalien für die Prozessierung von Halbleitersubstraten verwendet. Viele der Chemikalien besitzen Komponenten, die permanent in oder auf dem Substrat zurückbleiben, andere Chemikalien wiederum werden nach der Verwendung wieder von der Oberfläche des Substrats entfernt. Eine der bekanntesten Materialklassen, die nach der Verwendung wieder entfernt werden müssen, sind die Fotolacke. Die Druckschrift

US 2012/0304921 A1 offenbart ein Heizgerät mit einem ersten Heizteil und einem zweiten Heizteil, zwischen denen ein Substrat angeordnet ist. Ein Abstandskontrollteil kontrolliert zumindest den Abstand des Substrats und dem ersten oder zweiten Heizteil.

Fotolacke werden vorwiegend für die Herstellung einer Oberflächenmaske verwendet. Der Fotolack wird dabei zuerst durch einen Beschichtungsprozess auf die Oberfläche eines Substrats aufgebracht. Die gängigsten Arten der Aufbringung sind dabei die Schleuderbelackung und die Sprühbelackung. Die Dicke der Fotolackschicht liegt dabei regelmäßig im Mikrometerbereich. Nach dem Auftragen der Fotolackschicht erfolgt sehr oft ein Wärmebehandlungsschritt, welcher das Lösungsmittel verdampfen lässt und den reinen, teilweise ausgehärteten Lack an der Oberfläche des Substrats zurücklässt. Nach diesem Wärmebehandlungsschritt kann eine Belichtung des Fotolacks erfolgen.

Die Entfernung von Schichten (Reinigung), insbesondere Fotolackschichten, geschieht in speziellen Prozessanlagen, die man grob in zwei Gruppen unterteilt kann.

Die erste Gruppe von Prozessanlagen sind sogenannte Batchprozessanlagen. In einer Batchprozessanlage werden mehrere Wafer an einer Haltevorrichtung fixiert und in ein Bad getaucht. Das Bad besteht aus einer Chemikalie die für den Entfernungsprozess (engl.: stripping )der Schicht verwendet wird. Die Batchprozessanlage kann entweder hydrostatisch oder hydrodynamisch ausgelegt sein. In der ersten Variante handelt es sich um eine Bad mit stehender, daher nicht zirkulierender, Flüssigkeit. Der Vorteil dieser Ausführungsform besteht darin, dass man nur sehr geringe Mengen an Chemikalien benötigt. Der gravierende Nachteil liegt in der Verschmutzung der Chemikalie durch die abgelöste Schicht. Im Laufe des Reinigungsprozesses erhöht sich die Konzentration der Schichtkomponenten. Damit sinkt gleichzeitig die Reinigungseffizienz. Des Weiteren steigt die Abscheiderate der nicht abgeführten Schichtkomponenten auf den bereits gereinigten Wafern, sodass im Mittel selten eine vollständige, hochreine Oberflächenreinigung der Substrate erfolgt. Die Chemikalie kann zwar nach einer gewissen Anzahl von prozessierten Wafern gewechselt werden, die Wände des Behälters, in dem sich die Chemikalie befindet, bleiben allerdings meistens kontaminiert. Bei der hydrodynamischen Variante wird die Chemikalie laufend erneuert und die von der Oberfläche der Substrate entfernten Schichtkomponenten werden abgeführt, bevor es überhaupt zu einer erneuten Kontamination der Substratoberflächen oder der Wände des Behälters kommt. Batchprozessanlagen benötigen also im Allgemeinen große Mengen an Chemikalien und versuchen daher entsprechend hohe Chemikalienkosten. Des Weiteren wird die Umwelt durch die großen Chemikalienmengen unnötig belastet.

Die zweite Gruppe von Prozessanlagen sind sogenannte Einzelsubstratprozessanlagen, die man bei der Verwendung von Wafern auch Einzelwaferprozessanlagen bezeichnen kann. Dieser Anlagentyp erlaubt nur eine serielle Prozessierung von Substraten. Am Beginn des Reinigungsprozesses wird die Chemikalie auf die zu entfernende bzw. zu reinigende Schicht, insbesondere Fotolack, aufgebracht. Die Chemikalie verweilt eine gewisse Zeit auf der Oberfläche des Substrats, löst die Schicht, und wird danach gezielt entfernt. Die Entfernung erfolgt mit Vorzug durch Abschleudern. Das Substrat wird daher bevorzugt auf einem Substrathalter eines Schleuderbelackers fixiert. Die Aufbringung der Chemikalie erfolgt über Sprühdüsen oder Schläuche.

Einzelsubstratprozessanlagen heizen die Chemikalien genauso wie Batchprozessanlagen. Die Temperierung der Chemikalien ist nötig, um eine chemische Reaktion mit der zu entfernenden Schicht zu starten und/oder voranzutreiben und/oder zu beschleunigen. Die Aufheiz- und/oder Abkühlraten, genauso wie die Heizzeiten und Heiztemperaturen sind im Allgemeinen abhängig von allen am Prozess teilnehmenden Materialien, daher von der Schicht und/oder von der Chemikalie.

Einzelsubstratprozessanlagen haben mehrere entscheidende Vorteile gegenüber den Batchprozessanlagen. Sie verbrauchen viel weniger Chemikalien, können die verunreinigten Chemikalien sehr leicht aus dem System abführen, benötigen weniger Energiezufuhr da nur eine geringere Menge an Chemikalien aufgeheizt werden muss und sind damit im Ganzen meist billiger, obwohl der Durchsatz der Wafer pro Zeiteinheit im Allgemeinen geringer ist. Des Weiteren hat sich gezeigt, dass die Ausbeute an korrekt prozessierten Wafern bei Einzelsubstratprozessanlagen im Allgemeinen besser ist als bei Batchprozessanlagen.

Obwohl die Einzelsubstratprozessanlagen daher eine echte Alternative zu den Batchprozessanlagen darstellen, stellt die steuerbare, exakte und reproduzierbare Temperierung der Chemikalie ein technisches Problem dar. In einer Batchprozessanlage ist es dagegen sehr einfach, eine homogene, gezielt einstellbare und reproduzierbare Temperatur herzustellen, da das Chemikalienbad groß im Vergleich zu den Substraten ist, die behandelt werden sollen.

Bei den Einzelsubstratprozessanlagen reicht die geringe Menge an Chemikalie, welche die Oberfläche eines zu reinigenden Substrats bedeckt, zwar aus, um eine Lösung der Schicht von der Oberfläche zu bewirken, ist aber nicht groß genug, um im Sinne der statistischen Physik und Thermodynamik als Wärmepuffer zu wirken. Des Weiteren benetzt die Chemikalie bei Einzelsubstratprozessanlagen nur eine Seite des Substrats, während das Substrat in Batchprozessanlagen vollständig von Flüssigkeit umgeben ist und damit das Substrat optimal durchwärmt wird.

Es hat sich in den letzten Jahren allerdings gezeigt, dass gerade das konstante Einhalten der Temperatur von entscheidender Bedeutung für einen effizienten, vollständigen, wirtschaftlichen und reproduzierbaren Reinigungsprozess ist. Es reicht nicht, die Chemikalie über eine gewisse kritische Temperatur zu erhitzen. Das Prozessfenster in welchem die optimale Reinigung erfolgt ist sehr eng und präzise einzuhalten.

Ein technisches Problem besteht in der im Regelfall einseitigen Heizung, so dass ein Wärmegradient vorhanden ist, der die Temperatur der Flüssigkeit, insbesondere Reinigungsflüssigkeit, stark beeinflusst.

Aufgabe der vorliegenden Erfindung ist es daher, ein, insbesondere auf Einzelsubstratprozessanlagen bezogenes, Verfahren und eine Vorrichtung zum Behandeln, insbesondere Reinigen einer, insbesondere mit Fotolack beschichteten, Substratoberfläche vorzusehen, bei welchem die Reinigung günstiger und schneller, insbesondere auch umweltschonender erfolgt.

Diese Aufgabe wird mit den Merkmalen der Ansprüche 1 und 8 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Die Erfindung beschreibt eine Vorrichtung und ein Verfahren, um eine Flüssigkeit, mit Vorzug eine Chemikalie zur Behandlung, insbesondere Reinigung, einer Oberfläche, auf möglichst konstanter Temperatur zu halten und mit Vorzug gleichzeitig eine möglichst homogene Temperaturverteilung zu gewährleisten. Obwohl die erfindungsgemäße Ausführungsform mit Vorzug für Reinigungsprozesse Verwendung findet, kann man sie für alle Prozesse verwenden, in denen eine Flüssigkeit auf konstanter Temperatur gehalten werden muss. Denkbare Prozesse wären
- Reinigung einer Oberfläche
- Temperaturbehandlung eines Temporärklebers, mit Vorzug zum Ausdampfen des Lösungsmittels
- Entwicklerprozess
- Nasschemische Abscheidung einer Komponente aus der Chemikalie an der Substratoberfläche
- Elektrochemische Deposition
- (nasschemischer) Ätzprozess
- Selbstorganisationsprozesse von Molekülen
- Lift-Off Prozess

Die Erfindung wird dabei hauptsächlich zur Temperierung von Chemikalien verwendet, welche zum Strippen, also zur Entfernung, von einer Schicht, vorzugsweise Fotolack, von der Oberfläche von Substraten, insbesondere Wafern, verwendet werden. Der Erfindung liegt dabei vor allem die Idee zu Grunde, die optimale Temperatur insbesondere zum Strippen durch einen nicht in die Chemikalie eintauchenden, sondern sich über der Chemikalie in einer steuerbaren Position befindenden, Heizer konstant zu halten.

Die erfindungsgemäße Methode und Anlage kann grundsätzlich für die gezielte Temperaturregelung einer jeden Flüssigkeit verwendet werden. Mit Vorzug wird aber vor allem die Regulierung der Temperatur einer Flüssigkeitsschicht durchgeführt, deren Dicke klein ist im Vergleich zu deren lateralem Durchmesser, insbesondere mit einem Verhältnis kleiner 1 zu 10, vorzugsweise kleiner 1 zu 100. Bei der Flüssigkeit kann es sich um jede Art von Chemikalie, mit Vorzug Reinigungschemikalie, handeln. Mit Vorzug handelt es sich allerdings um eine Chemikalie zum Strippen von Fotolacken. Erfindungsgemäß könnten insbesondere folgende Chemikalien verwendet werden:
- Azeton,
- Propylenglycolmonomethyletheracetat (PGMEA),
- Mesitylene,
- Serien von der Firma MicroChemicals, AZ 100, TechniStrip P1316, TechniStrip NI555, TechniStrip NI105,
- DMSO und NMP,
- TMA
- Amine
- Ketone
- Piranha Etch
- Acetonitril
- Anilin
- Cyclohexan
- n-Pentan
- Triethylenglycoldimethylether (Triglyme)
- Dimethylacetamid
- Dimethylformamid
- Dimethylsulfoxid
- 1,4-Dioxan
- Eisessig
- Essigsäureanhydrid
- Essigsäureethylester
- Ethanol
- Ethylendichlorid
- Ethylenglycol
- Anisol
- Benzol
- Benzonitril
- Ethylenglycoldimethylether
- Petrolether/Leichtbenzin
- Piperidin
- Propanol
- Propylencarbonat (4-Methyl-1,3-dioxol-2-on)
- Pyridin
- γ-Butyrolacton
- Chinolin
- Chlorbenzol
- Chloroform
- n-Heptan
- 2-Propanol (Isopropylalkohol)
- Methanol
- 3-Methyl-1-butanol (Isoamylalkohol)
- 2-Methyl-2-propanol (tert-Butanol)
- Methylenchlorid
- Methylethylketon (Butanon)
- N-Methyl-2-pyrrolidon (NMP)
- N-Methylformamid
- Tetrahydrofuran
- Milchsäureethylester
- Toluol
- Dibutylether
- Diethylenglycol
- Diethylether
- Brombenzol
- 1-Butanol
- tert-Butylmethylether (TBME)
- Triethylamin
- Triethylenglycol
- Formamid
- n-Hexan
- Nitrobenzol
- Nitromethan
- 1,1,1-Trichlorethan
- Trichlorethen
- Schwefelkohlenstoff
- Sulfolan
- Tetrachlorethen
- Tetrachlorkohlenstoff
- Wasser
- Säuren, insbesondere
   ▪ H₂SO₃,H₂SO₄, HCL, H₃PO₄, HNO₃, H₂O₂, Ameisensäure, Essigsäure,
- Laugen, insbesondere
   ▪ NaOH, KOH, Tetramethylammoniumhydroxid (TMAH),
- Mischungen der vorgenannten Chemikalien.

Der technische Vorteil der Erfindung besteht in der geringen Menge an verwendetem Lösungsmittel, welches gezielt auf eine Temperatur gebracht werden kann und dessen Temperatur kontinuierlich überwacht und im Bedarfsfall schnell genug geregelt werden kann, um den Lösungsprozess in einem sehr begrenzten, engen Prozessfenster ablaufen zu lassen. Durch die entsprechend genaue Steuerung/Regelung der Reinigungstemperatur, insbesondere bei konstanter Heizflächentemperatur, erfolgt eine sehr effiziente und wiederholbare Reinigung der zu reinigenden Substratoberfläche. Des Weiteren wird mit der erfindungsgemäßen Ausführungsform eine homogene, daher eine vom Ort unabhängige, Temperaturverteilung erzielt. Die Temperaturhomogenität ist von Bedeutung, um die gleichmäßige Abtragung der Schicht vom Substrat zu gewährleisten.

Die erfindungsgemäße Ausführungsform besteht in einer Ausführungsform der Erfindung aus einem Substrathalter und einem über und/oder unter dem Substrathalter befindlichen Heizer mit einer Heizfläche. Der Substrathalter ist so konstruiert, dass er ein Substrat, mit Vorzug einen Wafer, mit größerem Vorzug einen Halbleiterwafer, mit größtem Vorzug einen Siliziumwafer, fixieren kann und durch eine seitliche Umrandung eine auf dem Substrat aufgebrachte Flüssigkeit am Ablaufen hindert. Der Substrathalter ist so gebaut, dass das fixierte Substrat den Boden für die eingebrachte Flüssigkeit bildet und die Umrandung die Flüssigkeit am Ablaufen hindert. Die Umrandung bildet mit dem auf dem Substrathalter aufliegenden Substrat eine Wanne zur Aufnahme des Reinigungsmittels während der Reinigung. Zur konstruktiven Ausführung wird insbesondere auf die Offenbarung PCT/US2012/066204 Bezug genommen.

Der Substrathalter befindet sich mit Vorzug auf einer Welle, welche um Ihre Achse in Rotation versetzt werden kann. Dadurch wird die Entfernung der Chemikalie nach dem erfolgten Reinigungsschritt durch Abschleudern ermöglicht. Des Weiteren kann die Drehung des Substrathalters während des Reinigungsprozesses erfindungsgemäß zu einer Homogenisierung der Temperatur entlang der Substratoberfläche und damit zu einer homogeneren Reinigung und Ablösung der Schicht von der Substratoberfläche genutzt werden. Die Homogenisierung der Temperatur wird am idealsten bei möglichst kleinen Drehzahlen des Substrathalters erreicht. Die Anzahl der Umdrehungen pro Minute (engl.: rounds per minute, rpm) ist dabei kleiner als 3000, mit Vorzug kleiner als 1000, mit größerem Vorzug kleiner als 500, mit größtem Vorzug kleiner als 100, mit allergrößtem Vorzug kleiner als 50, am bevorzugtesten zwischen 30 und 0. Anstatt der Drehung wäre auch eine leichte Oszillation des Substrathalters um die Welle denkbar. Der Substrathalter führt dann erfindungsgemäß eine Torsionsschwingung um die Wellenlängsachse durch. Die bevorzugte Torsionsfrequenz liegt dabei unter 100 Hz, mit Vorzug unter 50 Hz, mit größerem Vorzug zwischen 30 und 0 Hz. Die Chemikalie wird mit Vorzug zusätzlich mit Ultraschall beaufschlagt um eine effizientere Wirkung zu entfalten. Vor allem bei der Verwendung von Reinigungsflüssigkeiten kann sich Ultraschall vor allem positiv auf die Reinigung der Oberfläche auswirken. Des Weiteren wird die Reinigungszeit reduziert. Das Ultraschallgerät ist mit Vorzug direkt im Substrathalter eingebaut, kann allerdings auch durch einen Schwenkarm über die Flüssigkeit bewegt und eingetaucht werden.

Mit Vorzug befindet sich ein Heizer über der Substrathalterung, mit einer zum Substrat weisenden Heizfläche. Bei dem Heizer handelt es sich insbesondere um einen Flächenheizer. Der Flächenheizer besitzt eine 0.1-mal so große Heizfläche, mit Vorzug eine ebenso große Heizfläche, mit größerem Vorzug eine 1.5-mal so große Heizfläche und mit allergrößtem Vorzug eine doppelt so große Heizfläche wie die zu reinigende Substratoberfläche.

Die Form des Flächenstrahlers ist mit Vorzug kongruent zur Form des Substrats. Da in der Halbleiterindustrie meistens kreisrunde Substrate verwendet werden, besitzt der Heizer daher bevorzugt eine kreisrunde Form. Die Form des Heizers kann auch rechteckig oder an die spezielle Formen des Substrats angepasst sein. Der Heizer ist entweder ein Vollflächenheizer oder ein Zonenheizer. Bei einem Vollflächenheizer kann nur die Temperatur der gesamten Heizfläche eingestellt und geändert werden. Bei einem Zonenheizer kann die Temperatur für einzelne Segmente des Heizers geregelt werden. Die bevorzugteste Ausführungsform eines Zonenheizers besteht nur aus einem zentralen, zentrischen, kreisrunden Heizelement und mindestens einem ringförmigen, zentrierten Heizelement, welches das zentrale Heizelement umschließt. In einer ganz speziellen Ausführungsform ist der Heizer wie ein Kreissegment geformt. Um eine entsprechende vollflächige Temperaturbeaufschlagung der Chemikalie zu ermöglichen, erfolgt eine Relativrotation zwischen der Chemikalie bzw. dem Probenhalter und der Heizfläche bzw. dem Heizer. Diese spezielle Form des Heizers dient vor allem der Kompensation von örtlich unterschiedlichen Wärmeableiteigenschaften. Mit Vorzug bewegt sich in dieser speziellen Ausführungsform allerdings der Heizer, damit die Flüssigkeit keine unnötigen Schwankungen erfährt. Die Relativrotation zwischen der Chemikalie bzw. dem Probenhalter am idealsten bei möglichst kleinen Drehzahlen des Substrathalters erreicht. Die Anzahl der Umdrehungen pro Minute ist dabei kleiner als 3000, mit Vorzug kleiner als 1000, mit größerem Vorzug kleiner als 500, mit größtem Vorzug kleiner als 100, mit allergrößtem Vorzug kleiner als 10, am bevorzugtesten kleiner als 1. In einer ganz speziellen Ausführungsform können sich Probenhalter und Heizer gegenläufig zueinander bewegen.

Der Heizer wird erfindungsgemäß vorzugsweise an der Heizfläche auf eine Heiztemperatur größer 25°C, mit Vorzug größer 100°C, mit größerem Vorzug größer 200°C, mit größtem Vorzug größer 300°C, mit allergrößtem Vorzug größer als 400°C eingestellt. Die Genauigkeit bzw. Abweichung der Temperaturregelung nach unten oder oben ist dabei insbesondere besser als 10°C, mit Vorzug besser als 5°C, mit größerem Vorzug besser als 1°C, mit größtem Vorzug besser als 0,1°C, mit allergrößtem Vorzug besser als 0,01°C. In ganz besonderen Ausführungsformen wird die Temperatur der Flüssigkeit immer in der Nähe oder sogar leicht über dem Flammpunkt gehalten, da die angestrebte Behandlung, im speziellen die Reinigung, in diesen Temperaturbereich effizient durchgeführt werden kann.

Der Heizer ist in einem Abstand zur Substratoberfläche bzw. zur Oberfläche der Flüssigkeit bzw. Reinigungsflüssigkeit, insbesondere der Chemikalie, auf dem zu reinigenden Substrat angeordnet. Insbesondere während des Reinigungsprozesses kann es erfindungsgemäß nötig sein, den Abstand der Heizfläche zu der Oberfläche der Reinigungsflüssigkeit zu ändern, sodass der Heizer sich von der Flüssigkeitsoberfläche entfernt oder sich an diese annähert. Der bevorzugte Abstand des Heizers ist kleiner als 100 mm, mit Vorzug kleiner als 50 mm, mit größerem Vorzug kleiner als 25 mm, mit größtem Vorzug kleiner als 10 mm, mit allergrößtem Vorzug größer als 1 mm.

Insbesondere wird erfindungsgemäß ein Abstandskorridor für eine bestimmte Anwendung vorgegeben, der vorzugsweise empirisch ermittelt und in einer Steuerungseinrichtung zur Steuerung der Vorrichtung und der Verfahrensschritte hinterlegt ist. Innerhalb des Abstandskorridors ist die Heizfläche orthogonal zur Substratoberfläche bewegbar. Die erfindungsgemäße Bewegung wird insbesondere als Linearbewegung mit entsprechenden Antriebsmitteln ausgeführt.

In einer ersten, bevorzugten Ausführungsform sind Sensoren im Heizer integriert, mit deren Hilfe die Temperatur der Flüssigkeitsoberfläche bestimmt werden kann.

In einer zweiten, weniger bevorzugten aber denkbaren Ausführungsform sind die Sensoren im Probenhalter unter dem zu reinigenden Substrat integriert. Der Nachteil dieser Ausführungsform besteht darin, dass die zwischen den, im Probenhalter eingebauten Sensoren und der Chemikalie, liegenden Bauteile, die Temperatur verzerren und verfälschen können, da die Wärme über Wärmekonvektion und Wärmestrahlung auf dem Weg von der Chemikalie zu den Sensoren teilweise verloren gehen kann.

Erfindungsgemäß denkbar wäre eine Eichung der Sensoren durch ein Eichbad und ein Eichsubstrat. Im weiteren Verlauf der Patentschrift wird vor allem die bevorzugte erste Ausführungsform beschrieben.

Die Genauigkeit der Sensoren ist insbesondere besser als 10°C, mit Vorzug besser als 5°C, mit größerem Vorzug besser als 1°C, mit größtem Vorzug besser als 0.1°C, mit allergrößtem Vorzug besser als 0.01°C. Als Sensoren kommen erfindungsgemäß vorzugsweise Thermometer, Bolometer, oder Pyrometer in Frage. Die Temperaturmessung erfolgt mit Vorzug berührungslos, um keine Kontamination der Chemikalie mit unerwünschten Metallen zu erhalten und den Temperaturmesser möglichst selten reinigen zu müssen. Erfindungsgemäß denkbar wäre eine Messung der Temperatur durch einen Temperatursensor, der direkt in die Flüssigkeit eintaucht. Dieser Sensor liefert zwar keine ortsaufgelöste Temperaturdaten, aber eine sehr exakte, mittlere Temperatur der gesamten Flüssigkeit. In einer noch bevorzugteren Ausführungsform sind mehrere Temperatursensoren entlang des die Flüssigkeit begrenzenden Randes des Probenhalters auf Höhe des Flüssigkeitsvolumens montiert und erlauben so eine Temperaturmessung entlang des Umfangs der Flüssigkeit.

Der Heizer kann mehr als einen Sensor und/oder mehrere Sensortypen besitzen. Mit Vorzug sind mehrere Sensoren, insbesondere symmetrisch über den Heizer verteilt, mit größtem Vorzug in Form eines symmetrischen Musters, an dem Heizer, insbesondere an der Heizfläche, angeordnet. Dadurch wird eine in-situ Aufnahme der Temperaturverteilung der Flüssigkeitsoberfläche ermöglicht. Ist eine Verwendung mehrere Sensoren nicht möglich oder nicht erwünscht, befindet sich der einzelne Sensor mit Vorzug im Zentrum des Heizers.

Ein erfindungsgemäßer Aspekt besteht darin, den Heizer auf eine vorgegebene Temperatur vorzuwärmen. Die Temperatur liegt erfindungsgemäß insbesondere oberhalb der Reinigungstemperatur, da die an der Heizfläche erzeugte Wärmemenge nicht verlustfrei die Flüssigkeitsoberfläche erreicht, sondern teilweise verloren geht. Für sehr viele Anwendungen liegt die Temperatur des Heizers über dem Flammpunkt der Chemikalie. Nach dem Erreichen der Zieltemperatur des Heizers beginnt die Messung der Temperatur an der Flüssigkeitsoberfläche. Ist die Ist-Temperatur kleiner als die vorgegebene Soll-Temperatur (Flüssigkeitstemperatur), wird der Abstand zwischen Heizer und Flüssigkeitsoberfläche reduziert. Denkbar ist eine Annäherung des Heizers an die Flüssigkeitsoberfläche oder eine Annäherung der Flüssigkeitsoberfläche durch Hebung des Probenhalters an den Heizer bzw. die Heizfläche. Die erste Ausführungsform wird bevorzugt, da die Chemikalie dadurch nicht in z-Richtung bewegt wird und damit eine ruhigere Oberfläche aufweist. Im weiteren Verlauf der Patentschrift wird daher immer die bevorzugte Ausführungsform beschrieben, bei der der Heizer bewegt wird.

Die Annäherung erfolgt dabei durch Motorsteuerung abhängig von einem Algorithmus der Regelschleife. Durch eine Annäherung der, insbesondere an einer Heizplatte angeordneten, Heizfläche an die Flüssigkeitsoberfläche wird die für den erzeugten Wärmestrom zu überbrückende, Distanz verringert und dadurch wird bei gleicher Heizleistung weniger Wärmemenge zwischen Heizer und Flüssigkeitsoberfläche verloren.

Ist die Ist-Temperatur größer als die Soll-Temperatur, erfolgt die Kühlung indirekt, indem der Heizer durch die Regelschleife von der Flüssigkeitsoberfläche entfernt wird, wodurch sich ein größerer zu überbrückender Weg (Abstand zwischen Heizfläche und Flüssigkeitsoberfläche) für den Wärmestrom ergibt. Durch den größeren Weg geht mehr Wärmemenge aus dem Wärmestrom verloren, bevor die entsprechende Wärmemenge an der Flüssigkeitsoberfläche ankommt. Durch die stetig fortschreitende Wärmeabgabe der Flüssigkeit, des Substrats und der gesamten erfindungsgemäßen Ausführungsvorrichtung selbst kommt es daher zu einer konstanten Abkühlung und dadurch zu einem Konvergieren der Ist-Temperatur an die Soll-Temperatur.

Der Motor zur Linearbewegung des Heizers in z-Richtung (orthogonal zur Heizfläche und/oder der Flüssigkeitsoberfläche und/oder der Substratoberfläche) und der Sensor zur Bestimmung der Temperatur der Flüssigkeitsoberfläche sind insbesondere über einen Regelkreis miteinander verbunden. Bei dem Regelkreis handelt es sich vorzugsweise um einen Software- und/oder Hardware-Proportional-Integral-Differentialkontroller (PID-Controller).

Ein weiterer erfindungsgemäßer Aspekt besteht einerseits darin, dass weder das Substrat oder der Substrathalter noch der Heizer kontinuierlich ihre Temperatur ändern müssen. Eine Temperaturänderung eines Substrathalters und/oder eines Heizers ist entsprechend kostenintensiv, langwierig und schwer steuerbar. Das gilt vor allem dann, wenn Substrathalter und/oder Heizer eine hohe Wärmekapazität und eine geringe Wärmeleitfähigkeit besitzen und damit die Änderung der Temperatur entsprechend lange Zeit in Anspruch nimmt, vor allem, wenn die zu ändernde Temperaturdifferenz groß ist. Erfindungsgemäß wird nur der Heizer auf einer konstanten Temperatur gehalten. Soweit der Heizer an der Heizfläche eine vorgegebene Heizflächentemperatur erreicht hat, erfolgt die Regelung der Flüssigkeitstemperatur, insbesondere ausschließlich, über die Annäherung oder Bewegung der Heizfläche des Heizers in z-Richtung. Der Heizer wird durch den PID Controller und die Messdaten der Temperatursensoren so in seiner z-Position verschoben, dass die Ist-Temperatur so gut wie möglich der Soll-Temperatur, der Prozesstemperatur des Strippens, gleicht.

Ein weiterer erfindungsgemäßer Aspekt besteht darin, dass der Heizer nicht mehr in die Chemikalie eintauchen muss, also berührungslos bzw. kontaktlos heizt. Dadurch werden gleich mehrere Probleme gelöst. Erstens kann es beim Eintauchen eines bereits auf Temperatur gebrachten Heizers, oder eines Heizers der kalt in die Chemikalie eintaucht und danach auf Temperatur gebracht wird, zu einem spontanen oder zumindest langsamen Verdampfen der Chemikalie durch Überhitzung kommen. Dies wird erfindungsgemäß vermieden.

Zweitens wird durch das Nichteintauchen der des Heizers die Chemikalie, und damit die Oberfläche des Substrats, nicht mit den Metallen des Heizers verunreinigt. Die Heizer sind insbesondere mit unterschiedlichen Metallen beschichtet, welche sich in den Chemikalien lösen können und damit vor- und/oder während und/oder nach der Einwirkung der Chemikalie auf die zu entfernende Schicht auch die Substratoberfläche kontaminieren, was zu gravierenden Problemen führen kann, wenn sich dort funktionale Einheiten wie beispielsweise Mikrochips oder Speicherchips befinden.

Drittens wird eine Kontamination der Oberfläche des Heizers durch die Chemikalie zumindest weitgehend verhindert. Eine Verwendung eines mit einer Chemikalie kontaminierten Heizers führt außerdem zu einer extrem inhomogenen Temperaturverteilung, was sich bei der nächsten zu reinigenden Charge entsprechend negativ auswirken würde. Die inhomogene Temperaturverteilung kommt vor allem dadurch zustande, dass bei den entsprechend hohen Temperaturen die Chemikalie an der Oberfläche des Heizers aushärten kann und eine sehr schwer zu entfernende, ausgehärtete Kruste bildet. Da diese Verunreinigungen im Allgemeinen unregelmäßig an der Oberfläche des Heizers auftauchen, haben sie auch einen entsprechenden Effekt auf die Temperaturverteilung. Durch die regellose Verteilung der Verunreinigungen kommt es zur Ausbildung einer inhomogenen Temperaturverteilung, da Wärme an den Stellen der Verunreinigungen vom Heizer schwerer abgegeben werden kann.

Ein weiterer erfindungsgemäßer Aspekt besteht darin, dass durch das Auftragen der Flüssigkeit an nur einer Seite des Substrats die gegenüberliegende Seite des Substrats nicht kontaminiert wird. Weiterhin wird durch die Erhitzung des Heizers nur die oberflächennahe Region des Substrats, also die Flüssigkeitsschicht thermisch belastet, so dass nach dem Abschleudern der Flüssigkeit und der Entfernung des Substrats sofort ein neues Substrat auf einen Substrathalter positioniert werden kann, ohne dass vorher noch ein langwieriger Abkühlprozesses des Substrathalters und/oder des Heizers abgewartet werden müsste. Würde man beispielsweise die Chemikalie über einen heizbaren Substrathalter erwärmen, würde das gesamte Substrat durchwärmt werden. Außerdem könnte das nächste, noch kalte Substrat beim Laden auf einen heißen Substrathalter Schaden nehmen. Man müsste also vor dem Laden eines neuen Substrats den Substrathalter kühlen, was mit Energie, Zeit und Kosten verbunden wäre.

Bei der erfindungsgemäßen Ausführungsform wird die warme bzw. heiße Flüssigkeit abgeschleudert, und der Heizer in eine Sicherheitsposition mit größerem Abstand als beim Reinigen gefahren. Anschließend oder gleichzeitig wird das fertig prozessierte Substrat entfernt. Es bleibt ein vergleichsweise kühler, sauberer Substrathalter für die Reinigung des nächsten Substrats.

Während des Substrattausches bzw. des Entladens und Beladens eines neuen Substrats kann der Heizer erfindungsgemäß weiter auf der Heiztemperatur gehalten werden, so dass das Heizen sofort nach der Beladung des neuen Substrats und Aufbringen eines neuen Flüssigkeitsvolumens durch Annäherung des Heizers in Sekundenbruchteile erfolgen kann. Eine spontane Verdampfung der Chemikalie wird durch kontinuierliche Temperaturmessung über die Temperatursensoren im Heizer während der Annäherung und einem entsprechend frühzeitig gestoppten Heizer verhindert.

Ein weiterer erfindungsgemäßer Gedanke besteht darin, dass die erfindungsgemäße Vorrichtung dem unterschiedlichen Wärmeverlust des Substrathalters und des Substrats gerecht werden kann. Erfindungsgemäß können somit unterschiedliche Substrate mit unterschiedlichen Dicken, unterschiedlichen Schichten und unterschiedlichen Materialien mit ein und derselben erfindungsgemäßen Anlage behandelt werden.

In einer speziellen Ausführungsform ist der Heizer als Segmentheizer ausgeführt. Unter einem erfindungsgemäßen Segmentheizer versteht man einen in einzelne Segmente unterteilten Heizer, mit welchem die Heiztemperatur lokal in jedem einzelnen Segment separat angesteuert werden kann. Mit besonderem Vorzug ist in jedem Segment mindestens ein Temperatursensor angeordnet, um die Temperatur der Flüssigkeitsoberfläche direkt unter dem entsprechenden Segment und/oder die Heiztemperatur des jeweiligen Segments messen zu können.

Dabei kann es erfindungsgemäß vorgesehen sein, dass die Segmente des Heizers in der Aufsicht rechteckig geformt sind. In einer alternativen Ausführungsform sind die Segmente ringförmig angelegt, wobei jeder Ring entlang seines Umfanges mehrfach untereilt sein kann. In einer weiteren Ausführungsform existieren genau zwei Ringsegmente, eines am Rand und eines im Zentrum. In einer ganz besonderen Ausführungsform sind die Segmente wabenförmig, also sechseckig ausgeführt.

Mit Vorzug besitzt die erfindungsgemäße Ausführungsform eine Sicherheitsvorrichtung, welche das Eintauchen des Heizers in die Chemikalie verhindert. Dabei kann es sich um einen seitlich am Heizer angebrachten, auf eine Flüssigkeit sensitiv reagierenden Stift handeln und/oder um eine optische Abstandsmesseinrichtung und/oder um einen zu schließenden Stromkontakt, der eine Sicherung aktiviert.

Obwohl in den erfindungsgemäßen Ausführungsformen kein Heizer im Substrathalter vorgesehen ist, kann es unter gewissen Umständen von Vorteil sein, neben dem erfindungsgemäßen, vom Substrathalter getrennten Heizer, noch einen zusätzlichen Heizer direkt in den Substrathalter einzubauen oder nur einen im Substrathalter eingebauten Heizer zu verwenden. Ein solcher Heizer wäre vor allem für die Temperaturhomogenität, für das Vorheizen oder das Aufrechterhalten der Temperatur von Bedeutung. Ein Substrathalter mit einem eingebauten Heizer besitzt dann lediglich den Nachteil, dass eine Kühlung vor einer neuen Beladung zu erfolgen hat, sofern die entsprechende erfindungsgemäße Methode einen derartigen gekühlten Ausgangszustand verlangt. Alle für den eigentlichen, erfindungsgemäßen, vom Substrathalter getrennten Heizer, vorgesehenen Überlegungen bezüglich Temperatursensoren, Segmentierungen, translatorische Bewegung zur aktiven Temperaturregelung etc. gelten ebenfalls für einen in den Substrathalter eingebauten Heizer. Besonders beachten muss man, dass ein im bzw. unter dem Substrathalter eingebauter Heizer auch wieder so konstruiert sein kann, dass er eine translatorische Bewegung auf den Substrathalter zu oder vom Substrathalter weg durchführen kann. Dadurch wird wiederum die erfindungsgemäße aktive Temperaturregulierung der Flüssigkeit bzw. des gesamten Substrats von der Unterseite, nicht durch ein aktives Heizen und/oder Kühlen des Heizers sondern durch eine Bewegung des Heizers auf das Substrat oder vom Substrat ermöglicht. Die effizienteste Ausführungsform würde insbesondere in einer entsprechend dicken Hohlwelle bestehen, in welcher ein erfindungsgemäßer Heizer auf einer zweiten Hubwelle befestigt, innerhalb der Hohlwelle auf das Substrat zu bzw. vom Substrat weg bewegt werden kann. Natürlich könnte ein Heizer auch statisch im Substratprobenhalter eingebaut werden.

Das zu behandelnde Substrat ist während des Reinigungsprozesses mit Vorzug vollständig von der Flüssigkeit bedeckt.

Die erfindungsgemäße Reinigung erfolgt mit Vorzug in einer, insbesondere hermetisch abdichtbaren, über das Abheben eines Deckels zugänglichen, evakuierbaren Reinigungskammer. Die Reinigungskammer kann auf einen Druck von weniger als 1bar, mit Vorzug weniger als 1mbar, mit größerem Vorzug weniger als 0,1mbar, mit größtem Vorzug auf weniger als 0,01mbar mit allergrößtem Vorzug auf weniger als 0,0001mbar Absolutdruck evakuiert werden. Mit Vorzug erfolgt eine derartige Evakuierung vor dem Einbringen der Flüssigkeit. Ein entsprechend geringer Druck würde die meisten Flüssigkeiten bei zu geringen Temperaturen sieden lassen. Die Evakuierung kann aber nicht erwünschte Gaskomponenten, allen voran Sauerstoff, aus der Kammer entfernen und die Kammer so für die Spülung bzw. Auffüllung mit einem erwünschten, für den Prozess vorteilhaften Gas, mit Vorzug einem Inertgas zur Flamm- und Brennhemmung, vorbereiten.

Die Reinigungskammer besitzt mit Vorzug eine vollautomatisch steuerbare und programmierbare Abgassteuerung. Der Volumenstrom der Abgasleitung liegt dabei zwischen 1m³/h und 1000 m³/h, mit Vorzug zwischen 50m³/h und 750 m³/h, mit größtem Vorzug zwischen 100m³/h und 500 m³/h, mit allergrößtem Vorzug zwischen 70m³/h und 150 m³/h. In einer besonderen Ausführungsform ist es möglich, die Reinigungskammer über ein Ventil mit einem Gas zu füllen. Die Reinigungskammer kann dann mit Vorzug auch auf Überdruck beansprucht werden. Der Druck ist dabei größer gleich 0.1 Pa (0.001 mbar) mit Vorzug größer als 10 Pa (0.1 mbar) mit größerem Vorzug größer als 100 Pa (1 mbar), mit größtem Vorzug größer als 100 kPa (1 bar), mit allergrößtem Vorzug größer als 500 kPa (5 bar). Besonders Vorteilhaft sind eine Evakuierung der Kammer (insbesondere auf einen Druck von weniger als 100 kPa (1 bar), mit Vorzug weniger als 100 Pa (1 mbar), mit größerem Vorzug weniger als 10 Pa (0. 1 mbar), mit größtem Vorzug auf weniger als 1 Pa (0.01 mbar) mit allergrößtem Vorzug auf weniger als 0.01 Pa (0.0001 mbar) nach dem Laden des Substrats zur Entfernung ungewollter Luftbestandteile und ein anschließendes Auffüllen mit einem Gas (insbesondere mit den oben genannten Parametern), welches sich positiv auf den erfindungsgemäßen Prozess auswirkt. Dabei handelt es sich mit Vorzug um Gase, welche eine Zündschwelle der Chemikalie herabsetzen, indem Sie den Sauerstoff verdrängen bzw. ersetzen und die mit Vorzug selbst nicht oder nur sehr schwer oxidierbar sind. Beispiele hierfür wären Stickstoff, Helium, Argon, Krypton. Besonders bevorzugt wären auch Gase, mit einer besonders niedrigen Wärmekapazität und einer hohen Wärmeleitfähigkeit. Je geringer die Wärmekapazität, desto weniger Wärmemenge kann ein Gas pro Temperatureinheit speichern und desto geringer sollte die Verzögerung der Wärmeänderung an der Chemikalienoberfläche bei eingeleiteter Temperaturänderung am Heizer sein. Das System sollte daher bei Verwendung eines Gases mit möglichst geringer Wärmekapazität eine möglichst geringe thermische Trägheit besitzen. Die spezifische Wärmekapazität des verwendeten Gases sollte daher kleiner als 10 J/(g*K), mit Vorzug kleiner als 5 J/(g*K), mit größerem Vorzug kleiner als 2 J/(g*K), mit noch größerem Vorzug kleiner als 1 J/(g*K), mit größtem Vorzug kleiner als 0.5 J/(g*K), mit allergrößtem Vorzug kleiner als 0.1 J/(g*K) sein. Gleichzeitig sollte die Wärme möglichst schnell vom Heizer zur Chemikalie transportiert werden. Entsprechend groß sollte die thermische Leitfähigkeit des Gases sein. Die thermische Leitfähigkeit sollte daher größer als 10⁻³ W/(m*K), mit Vorzug größer als 10⁻² W/(m*K), mit größerem Vorzug größer als 10⁻¹ W/(m*K), mit größtem Vorzug größer als 1 W/(m*K), mit allergrößtem Vorzug größer als 10 W/(m*K), am bevorzugtesten größer als 100 W/(m*K) sein. Mit besonderem Vorzug können auch Gasgemische, bestehend aus einem Inertgas und einem für die effiziente thermische Kontaktierung verantwortliches Gas, gemischt werden.

Die Flüssigkeit wird nach der Aufnahme des Substrats auf den Substrathalter über einen Schlauch und/oder über Düsen aufgebracht. Bei der Verwendung von Düsen werden mit Vorzug mehr als eine Düse, mit größerem Vorzug mehr als 5 Düsen, mit größerem Vorzug mehr als 10 Düsen, mit allergrößtem Vorzug mehr als 50 Düsen für die Aufbringung der Flüssigkeit benutzt. Mit besonderem Vorzug können sich der Schlauch und oder die Düsen im Substrathalter befinden, sodass ein sehr nahe an den Substrathalter herangebrachter Heizer die Abscheidung der Chemikalie nicht behindert.

Die Flüssigkeit läuft mit Vorzug über einen Wärmetauscher, bevor Sie auf die Oberfläche des Substrats abgeschieden wird. Dadurch erreicht man bereits ein Vorheizen der Flüssigkeit. Bei der Wärmequelle des Wärmetauschers kann es sich um die Abwärme des Heizers und/oder der abgeschleuderten alten Flüssigkeit und/oder um eine elektrische Heizung handeln.

Nach dem Abschleudern der Chemikalie von der Oberfläche des Substrats kann eine Reinigung mit einer frischen Chemikalie und/oder mit Wasser erfolgen.

Am Ende des Reinigungsprozesses kann das Substrat vor der Entnahme mit DI-Wasser (deionisiertes Wasser) gereinigt werden. Die Reinigung erfolgt mit Vorzug über eine oder mehrere Düsen.

Die erfindungsgemäße Vorrichtung ist gemäß einer vorteilhaften Ausführungsform mit einem internen Feuerlöschsystem ausgestattet, welches über einen Feuermelder und/oder mindestens eine Absaugung und/oder eine Zufuhr zur Spülung mit Inertgas verfügt. Durch die Verwendung eines Feuerlöschsystems, einer evakuierbaren und mit Inertgas füllbaren Kammer, eines aktiv Steuerbaren Reglers wird es damit erfindungsgemäß besonders einfach, eine Flüssigkeit über ihre Flammpunkt zu erhitzen ohne dass es zur spontanen Zündung kommt. Damit wird erfindungsgemäß erstmals eine Anlage beschrieben, die eine Flüssigkeit über deren Flammpunkt kontrolliert auf Temperatur halten kann, ohne dass es zur Zündung der Flüssigkeit kommt.

Ein erfindungsgemäßer Prozess zur Reinigung einer Oberfläche eines Substrats sieht insbesondere einen oder mehrere der folgenden Schritte, vorzugsweise in der nachfolgend genannten Abfolge, vor:
- Laden eines zu reinigenden Substrats auf den Substrathalter, insbesondere unter Ausbildung einer Wanne zur Aufnahme einer (Reinigungs-)Flüssigkeit,
- Abscheiden der, insbesondere vorgeheizten, (Reinigungs-)Flüssigkeit auf der Substratoberfläche,
- Annäherung einer, insbesondere vorgeheizten, Heizfläche eines Heizers und kontinuierliche Messung der Heiztemperatur an der Heizfläche und/oder der Reinigungstemperatur an der Flüssigkeitsoberfläche,
- Halten des Heizers an einer bevorzugten z-Position in definiertem Abstand über der Flüssigkeitsoberfläche, in welcher gewährleistet wird, dass die Flüssigkeitsoberfläche eine gewünschte Reinigungstemperatur besitzt,
- Kontinuierliches Messen der Temperatur der Flüssigkeitsoberfläche und, soweit nötig eine entsprechende Nachregelung der z-Position bzw. des Abstands des Heizers,
- Durchführung des Reinigungsprozesses, bis die Oberfläche des Substrats gereinigt ist,
- Verfahren des Heizers in eine Sicherheitsposition,
- Abschleudern der Chemikalie von der Substratoberfläche, insbesondere über einen, vorzugsweise mit einer Rampe abgeflachten, Rand der Wanne,
- Nachspülen und Reinigen der Substratoberfläche mit DI-Wasser,
- Entfernen des prozessierten Substrats aus der Vorrichtung.

Einige Schritte der genannten Abfolge müssen nicht durchgeführt werden. Des Weiteren ist es denkbar, dass nicht genannte Schritte in die obige Reihenfolge eingefügt werden. Denkbar wäre auch die parallele Ausführung mehrere Schritte.

Die erfindungsgemäße Vorrichtung ist mit Vorzug Teil eines Clustersystems, mit größerem Vorzug Teil eines Vakuumclustersystems, mit noch größerem Vorzug Teil eines Hochvakuumclustersystems, mit allergrößtem Vorzug Teil eines Ultrahochvakuumclustersystems. Erfindungsgemäß kann die erfindungsgemäße Ausführungsform daher in einem Modul untergebracht sein, welches über mindestens eine Schleuse zu einer Zentralkammer des Vakuumclusters getrennt ist. Durch die Schleuse kann erfindungsgemäß eine Trennung der Atmosphäre des Moduls, in dem sich die erfindungsgemäße Ausführungsform befindet, von den anderen Modulen, im Besonderen von der Zentralkammer des Vakuumclusters, gesteuert werden.

Der Vakuumcluster kann auf einen Druck von weniger als 100 kPa (1 bar), mit Vorzug weniger als 0.1 Pa(10⁻³ mbar) mit größerem Vorzug weniger als 10⁻³ Pa(10⁻⁵ mbar) mit größtem Vorzug weniger als 10⁻⁶ Pa (10⁻⁸ bar) evakuiert werden.

Das Modul, in welchem sich die erfindungsgemäße Vorrichtung befindet, kann, mit Vorzug unabhängig vom Vakuumcluster, auf einen Druck von weniger als 100 kPa (1bar), mit Vorzug weniger als 0.1 Pa (10⁻³ mbar), mit größerem Vorzug weniger als 10^{-3 Pa} (10⁻⁵ mbar) mit größtem Vorzug weniger als 10⁻⁶Pa (10⁻⁸ mbar) evakuiert werden.

Soweit vorliegend und/oder in der anschließenden Figurenbeschreibung Vorrichtungsmerkmale offenbart sind, sollen diese auch als Verfahrensmerkmale offenbart gelten und umgekehrt.

Weitere Merkmale und Ausführungsformen der Erfindung ergeben sich aus den Ansprüchen sowie der nachfolgenden Figurenbeschreibung zur Zeichnung. Die Zeichnung zeigt in:
- Figur 1: eine schematische Querschnittsansicht einer Ausführungsform einer erfindungsgemäßen Vorrichtung,
- Figur 2a: eine schematische Aufsicht einer erfindungsgemäßen ersten Ausführungsform einer erfindungsgemäßen Heizfläche,
- Figur 2b: eine schematische Aufsicht einer erfindungsgemäßen zweiten Ausführungsform einer erfindungsgemäßen Heizfläche,
- Figur 2c: eine schematische Aufsicht einer erfindungsgemäßen dritten Ausführungsform einer erfindungsgemäßen Heizfläche,
- Figur 2d: eine schematische Aufsicht einer erfindungsgemäßen vierten Ausführungsform einer erfindungsgemäßen Heizfläche,
- Figur 2e: eine schematische Aufsicht einer erfindungsgemäßen fünften Ausführungsform einer erfindungsgemäßen Heizfläche,
- Figur 2f: eine schematische Aufsicht einer erfindungsgemäßen sechsten Ausführungsform einer erfindungsgemäßen Heizfläche und
- Figur 3: eine schematische Darstellung eines erfindungsgemäßen Clustersystems mit einer erfindungsgemäßen Vorrichtung.

In den Figuren sind gleiche oder gleichwirkende Teile mit einheitlichen Bezugszeichen gekennzeichnet, wobei die Größenverhältnisse zur Veranschaulichung nicht maßstabsgetreu sind.

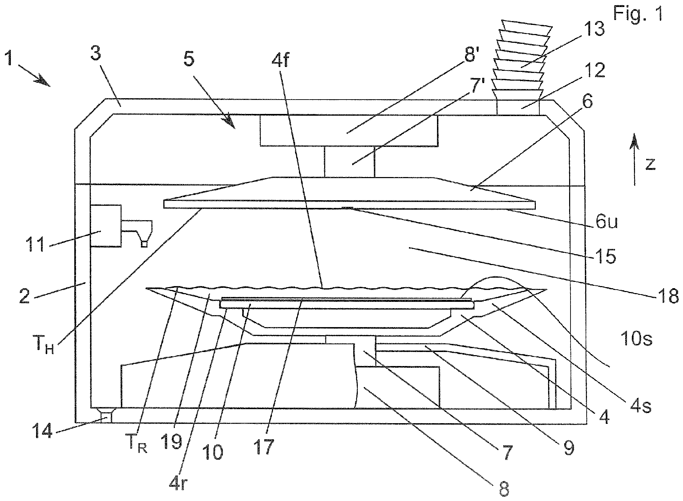

Figur 1 zeigt eine Ausführungsform eines erfindungsgemäßen Behandlungsmoduls 1. Das Behandlungsmodul 1 besteht aus einer unteren Gehäusehälfte 2 und einer oberen Gehäusehälfte 3. Die Gehäusehälften 2, 3 sind optional, werden aber mit Vorzug verwendet, insbesondere als abdichtbare Ausführung. Die obere Gehäusehälfte 3 ist mit Vorzug als Deckel ausgeführt, der abgenommen bzw. abgehoben oder um ein Scharnier gekippt werden kann, insbesondere gesteuert von einer Steuerungseinrichtung. Die Gehäusehälften 2, 3 sind bevorzugt hermetisch dicht ausgebildet, sodass ein Innenraum 18 evakuiert oder mit Überdruck zur Atmosphäre beaufschlagt werden kann.

Innerhalb der unteren Gehäusehälfte 2 ist ein Substrathalter 4 angeordnet. Der Substrathalter 4 ist insbesondere auf einer Hubwelle 7 fixiert. Die Hubwelle 7 erlaubt mit Vorzug nicht nur die rotatorische Bewegung des Substrathalters 4, sondern auch dessen Bewegung in z-Richtung, um das Laden eines Substrats 10 zu vereinfachen. Die Hubwelle 7, wird von einem entsprechenden Motor 8 gesteuert. Der Motor 8 kann mit einer Schutzhülle 9 bedeckt sein, um eine Kontamination mit einer (Reinigungs-)Flüssigkeit 19 beim Abschleudern der (Reinigungs)-Flüssigkeit 19 von dem Substrat 10 weitestgehend zu verhindern.

Die erfindungsgemäß denkbaren Ausführungsformen des Substrathalters 4 entsprechen mit Vorzug einer der Ausführungsformen der Patentanmeldung PCT/US2012/066204, auf die insofern Bezug genommen wird. Grundsätzlich sollte der Substrathalter 4 so konstruiert sein, dass der Wärmeabfluss über Wärmeleitung minimiert ist, und möglichst nur eine einseitige Erwärmung von der Seite einer oberhalb des Substrathalters angeordneten Heizeinrichtung 5 erfolgt. Sollte ein Heizer auch unterhalb des Substrathalters 4 angebracht sein, so ist der Wärmedurchfluss über Wärmeleitung maximiert.
Der Substrathalter 4 weist insbesondere eine Wannenform auf mit einem, insbesondere ringförmigen Absatz 4r zur Aufnahme des Substrats 10 an dessen Rückseite 10r, vorzugsweise ausschließlich in einem Seitenrandbereich, wobei ein Innenbereich des Substrats 10 zumindest weitgehend nicht unterstützt ist und über einem Wannenhohlraum 4h angeordnet ist.

Das Substrat 10 bildet mit einem Ringabschnitt 4s des Substrathalters eine, insbesondere wannenförmige, Flüssigkeitsaufnahme 4f aus. Diese ist vorzugsweise gegenüber der Rückseite 10r des Substrats abgedichtet.

Zumindest teilweise innerhalb der oberen Abdeckung 3 und vorzugsweise an dieser fixiert befindet sich ein Motor 8' mit einer Hubwelle 7' und einem Heizer 6 der Heizeinrichtung 5. Der Heizer 6 ist über die Hubwelle 7' in z-Richtung verstellbar. Die Ausführung der Welle als Hubwelle 7' erlaubt auch die Drehung des Heizers 6, was zu einer entsprechend besseren und vor allem homogeneren Temperaturverteilung führen kann. Denkbar wäre auch die Ausführung der Hubwelle 7' als einfacher Linearantrieb, während eine relative Rotationsbewegung zwischen dem Heizer 6 und den Substrathalter 4 durch die Hubwelle 7 erfolgt.

Der Heizer 6 hat eine Heizfläche 6u, die gegenüberliegend zu einer Substratoberfläche 10s angeordnet ist und erfindungsgemäß in einer z-Richtung auf diese zu und von dieser weg bewegt werden kann.

Der Innenraum 18 des erfindungsgemäßen Behandlungsmoduls 1 ist über eine Absaugöffnung 12 evakuierbar. Denkbar ist auch die Einleitung eines Gases oder Gasgemisches über die Absaugöffnung 12 und eine daran angeschlossene Absaugleitung 13. Entsprechend wird zwischen der Vakuumpumpe und der Absaugöffnung ein Ventil (nicht eingezeichnet) eingebaut sein, welches nach der erfolgreichen Evakuierung das Umschalten auf eine Gasquelle erlaubt. Denkbar wären auch eine zusätzliche, von der Absaugleitung 13 unabhängige, eigene Zuleitung bzw. mehrere Zuleitungen zum Innenraum 18.

Das Substrat 10 mit einer zu entfernenden Schicht 17, insbesondere Fotolack, wird auf dem Substrathalter 4 positioniert und fixiert. Danach erfolgt die Abscheidung einer (Reinigungs-)Flüssigkeit 19 über ein Abscheidesystem 11. Die Flüssigkeit 19 ist vorzugsweise vorgewärmt worden.

Der Heizer 6 wird an der Heizfläche 6u auf eine Heiztemperatur T_{H} aufgeheizt. Ein an der Heizfläche, insbesondere im Zentrum der Heizfläche 6u, angeordneter Temperatursensor 15 bzw. mehrere Temperatursensoren misst/messen die Heiztemperatur T an der Heizfläche 6u und/oder Reinigungstemperatur T_{R} der Flüssigkeit 19 an der Flüssigkeitsoberfläche 19f und regelt über einen PID Kontroller (nicht eingezeichnet), die Position des Heizers 6 solange, bis die Flüssigkeit 19 die vorgegebene Reinigungstemperatur T_{R} besitzt.

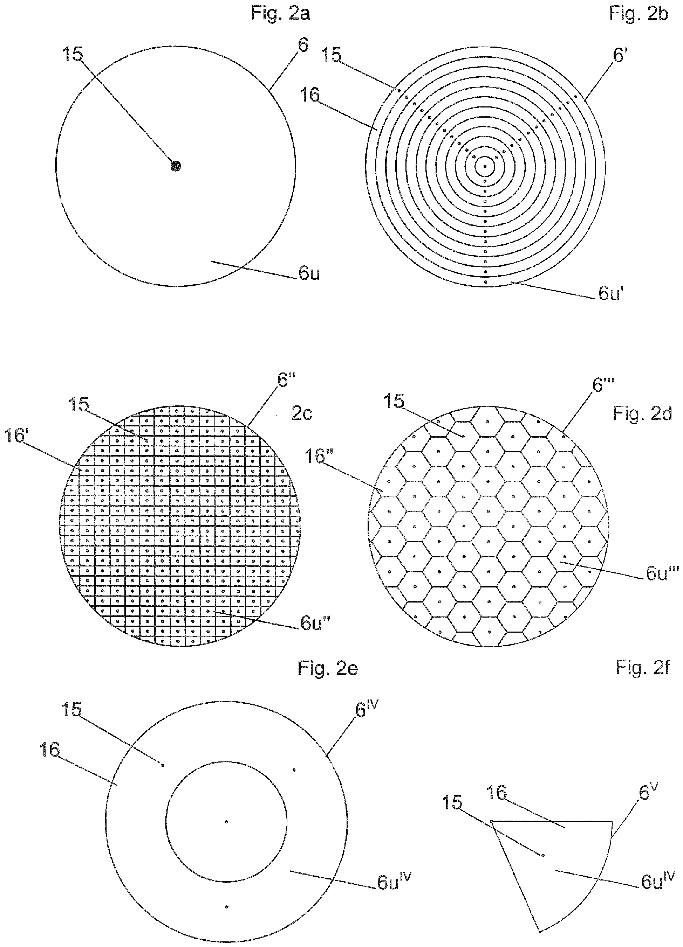

Die Figuren 2a-f zeigen mehrere Ausführungsformen von erfindungsgemäßen Heizern 6, 6', 6",6"', 6^{IV}, 6^{V}. Dargestellt sind die Heizflächen 6u, 6u', 6u",6u"', 6u^{IV}, 6u^{V} von sechs unterschiedlichen Heizern 6, 6', 6", 6''', 6^{IV}, 6^{V}.

In einer erfindungsgemäßen ersten Ausführungsform besteht der Heizer 6 aus einer vollflächigen Heizfläche 6u, bestehend aus einem einzelnen Segment. Im Zentrum der vollflächigen Heizfläche 6u befindet sich der Temperatursensor 15.

In einer zweiten erfindungsgemäßen Ausführungsform besteht der Heizer 6' aus einer aus Kreissegmenten 16' bestehenden Heizfläche 6u'. Jedes Kreissegment 16' (bis auf das im Zentrum) weist mehrere, insbesondere drei, Temperatursensoren 15, die am Umfang, insbesondere gleichmäßig, vorzugsweise jeweils in einem Winkelabstand von 120°, verteilt angeordnet sind.

In einer dritten erfindungsgemäßen Ausführungsform besteht der Heizer 6" aus rechteckigen Segmenten 16', in deren Zentrum sich jeweils ein Temperatursensor 15 befindet.

In einer vierten erfindungsgemäßen Ausführungsform besteht der Heizer 6"' aus wabenförmigen, sechseckigen Segmenten 16", in deren Zentrum sich jeweils ein Temperatursensor 15 befindet.

In einer fünften erfindungsgemäßen Ausführungsform entspricht der Heizer 6^{IV} im Wesentlichen der zweiten Ausführungsform, nur mit weniger, insbesondere genau zwei Kreissegmenten 16.

In einer sechsten erfindungsgemäßen Ausführungsform ist der Heizer 6^{V} als Kreissektor 16" ausgebildet, der insbesondere um ein Kreiszentrum drehbar ist.

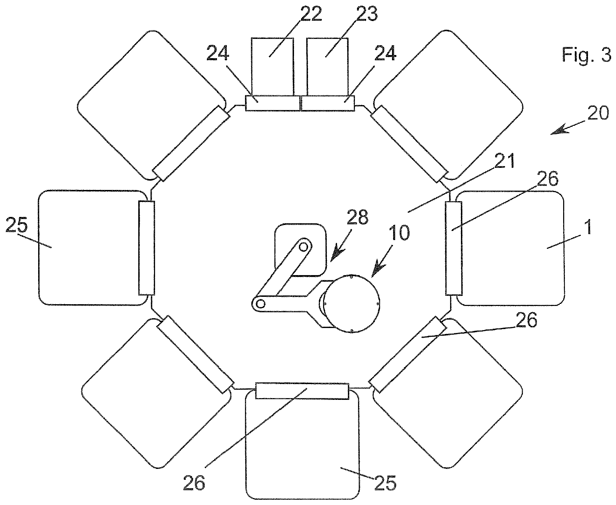

In einer Ausführungsform gemäß Figur 3 ist die erfindungsgemäße Vorrichtung als Behandlungsmodul 1 in einem Clustersystem 20 angeordnet, mit größerem Vorzug Teil eines Vakuumclustersystems, mit noch größerem Vorzug Teil eines Hochvakuumclustersystems, mit allergrößtem Vorzug Teil eines Ultrahochvakuumclustersystems. Das Behandlungsmodul 1 ist über mindestens ein Modulschleusentor 26 von einer Zentralkammer 21 des Clustersystems 20, insbesondere gedichtet, trennbar. Durch das Modulschleusentor 26 kann erfindungsgemäß eine Trennung der Atmosphäre des Behandlungsmoduls 1 von anderen Modulen 25, im Besonderen von der Zentralkammer 21, gesteuert werden.

Das Clustersystem kann auf einen Druck von weniger als 100 kPa (1 bar) mit Vorzug weniger als 0.1 Pa (10⁻³ mbar), mit größerem Vorzug weniger als 0.001 Pa (10-5 mbar) mit größtem Vorzug weniger als 10⁻⁶Pa (10⁻⁸ mbar), evakuiert werden.

Das Behandlungsmodul 1 kann, mit Vorzug unabhängig vom Druck in der Zentralkammer 21 oder anderen Modulen 25, auf einen Druck von weniger als 100 kPa (1 bar), mit Vorzug weniger als 0.1 Pa (10⁻³ mbar), mit größerem Vorzug weniger als 0.001 Pa (10⁻⁵ mbar), mit größtem Vorzug weniger als 10⁻⁶ Pa(10⁻⁸ mbar) evakuiert werden.

Innerhalb der Zentralkammer 21 transportiert ein Roboter 28 das Substrat 10 von einem der Modul 25 zu dem Behandlungsmodul 1. Das Substrat 10 gelangt zunächst über eine Schleuse 24 eines FOUP 22 für die einkommenden Substrate in die Zentralkammer 21. Nach einer erfolgreichen Prozessierung des Substrates 10 innerhalb des Clustersystems 20 legt der Roboter 28 das Substrat 10 über eine FOUP-Schleuse 24 in einem ausgehenden FOUP 23 ab.

### Verfahren und Vorrichtung zur Behandlung einer Substratoberfläche

### BEZUGSZEICHENLISTE

- 1: Behandlungsmodul
- 2: Untere Gehäusehälfte
- 3: Obere Gehäusehälfte
- 4: Substrathalter
- 4r: ringförmiger Absatz
- 4f: Flüssigkeitsaufnahme
- 4s: Ringabschnitt
- 5: Heizeinrichtung
- 6, 6', 6", 6'", 6^{IV}, 6^{V}: Heizer
- 6u, 6u', 6u", 6u''', 6u^{IV}, 6u^{V}: Heizfläche
- 7,7': Hubwelle
- 8, 8': Motor
- 9: Schutzhülle
- 10: Substrat
- 10s: Substratoberfläche
- 10r: Rückseite
- 11: Abscheidesystem
- 12: Absaugöffnung
- 13: Absaugleitung
- 14: Abfluss
- 15: Temperatursensor
- 16, 16', 16", 16"': Heizsegment
- 17: Schicht
- 18: Innenraum
- 19: Flüssigkeit
- 19f: Flüssigkeitsoberfläche
- 20: Clustersystem
- 21: Zentralkammer
- 22: Eingangs FOUP
- 23: Ausgangs FOUP
- 24: Schleuse
- 25: Module
- 26: Modulschleusentore
- 28: Roboter

## Patentansprüche

1. Verfahren zur Behandlung einer Substratoberfläche (10s) eines Substrats (10) durch Aufbringen einer Flüssigkeit (19) auf die Substratoberfläche (10s) oder auf eine auf der Substratoberfläche (10s) vorhandene Schicht (17), wobei die auf die Substratoberfläche (10s) aufgebrachte Flüssigkeit (19) durch eine oberhalb und/oder unterhalb der Substratoberfläche (10s) angeordnete Heizfläche (6u, 5u', 6u", 6u"', 6u^{IV}, 6u^{V}) geheizt wird, wobei eine Temperatur T_{R} der Flüssigkeit (19) durch Auf- und Abfahren der Heizfläche (6u, 6u', 6u", 6u"', 6u^{IV}, 6u^{V}) konstant gehalten wird, wobei das Substrat (10) einen Boden für die aufgebrachte Flüssigkeit (19) bildet und eine Umrandung (4s) eines Substrathalters (4) die Flüssigkeit (19) am Ablaufen hindert, **dadurch gekennzeichnet, dass** die Umrandung (4s) mit dem Substrat (10) eine Wanne zur Aufnahme der Flüssigkeit (19) während der Behandlung bildet.

2. Verfahren nach Anspruch 1, wobei eine Heizflächentemperatur T_{H} der Heizfläche (6u, 6u', 6u", 6u"', 6u^{IV}, 6u^{V}) zumindest während der Behandlung, insbesondere zusätzlich während eines Wechsels des zu reinigenden Substrats (10) und/oder während einer Vorwärmphase, konstant gehalten wird.

3. Verfahren nach einem der Ansprüche 1 oder 2, wobei die Heizfläche (6u, 6u', 6u", 6u'", 6u^{IV}, 6u^{V}) während der Behandlung parallel zur Substratoberfläche (10s) angeordnet wird.

4. Verfahren nach wenigstens einem der vorhergehenden Ansprüche, wobei das Substrat (10) mit seiner zur Substratoberfläche (10s) abgewandten Rückseite (10r) von dem, insbesondere rotierbaren, Substrathalter (4) gehalten wird.

5. Verfahren nach wenigstens einem der vorhergehenden Ansprüche, wobei die Heizfläche (6u, 6u', 6u", 6u''', 6u^{IV}, 6u^{V}) einen Mindestabstand von 1mm, insbesondere 10mm, vorzugsweise 25mm, noch bevorzugter 50mm, noch bevorzugter 100mm aufweist.

6. Verfahren nach wenigstens einem der vorhergehenden Ansprüche, wobei die Temperatur T_{R}, insbesondere ausschließlich, durch Steuerung/Regelung des Auf- und Abfahrens der Heizfläche (6u, 6u', 6u", 6u"', 6u^{IV}, 6u^{V}), konstant gehalten wird, insbesondere mit einer Abweichung von der Temperatur T_{R} von weniger als 5°C, vorzugsweise weniger als 1°C, noch bevorzugter weniger als 0,1°C, noch bevorzugter weniger als 0,001°C.

7. Verfahren nach wenigstens einem der vorhergehenden Ansprüche, wobei die Temperatur T_{R} und/oder die Heizflächentemperatur T_{H} zumindest während der Behandlung, insbesondere durch mindestens einen, vorzugsweise an der Heizfläche (6u, 6u', 6u", 6u"', 6u^{IV}, 6u^{V}) angebrachten, Temperatursensor (15), gemessen wird.

8. Vorrichtung zur Behandlung einer Substratoberfläche (10s) eines Substrats (10) durch Aufbringen einer Flüssigkeit (19) auf die Substratoberfläche (10s) oder auf eine auf der Substratoberfläche (10s) vorhandene Schicht (17) mit:
- einer oberhalb und/oder unterhalb der Substratoberfläche (10s) angeordneten Heizfläche (6u, 6u', 6u", 6u"', 6u^{IV}, 6u^{V}) zum Heizen der auf die Substratoberfläche (10s) aufgebrachten Flüssigkeit (19), Mitteln zum Auf- und Abfahren der Heizfläche (6u, 6u', 6u", 6u"', 6u^{IV}, 6u^{V}) und Konstanthalten einer Temperatur T_{R} der Flüssigkeit (19),
- **dadurch gekennzeichnet, dass** die Vorrichtung derart ausgebildet ist, dass durch eine Umrandung (4s) eines Substrathalters (4) die auf dem Substrat (10) aufgebrachte Flüssigkeit (19) am Ablaufen hinderbar ist, wobei mit dem Substrat (10) ein Boden für die Flüssigkeit (19) bildbar ist und die Umrandung (4s) mit dem Substrat (10) eine Wanne zur Aufnahme der Flüssigkeit (19) bildbar ist.

9. Vorrichtung nach Anspruch 8 mit dem, insbesondere rotierbaren, Substrathalter (4) zur Aufnahme des Substrats (10) mit seiner zur Substratoberfläche (10s) abgewandten Rückseite (10r).

10. Vorrichtung nach Anspruch 8 oder 9 mit mindestens einem, vorzugsweise an der Heizfläche (6u, 6u', 6u", 6u"', 6u^{IV}, 6u^{V}) angebrachten, Temperatursensor zur Messung der Temperatur T_{R} und/oder der Heizflächentemperatur T_{H}.

## Claims

1. A method for treatment of a substrate surface (10s) of a substrate (10) by applying a liquid (19) to the substrate surface (10s) or to a layer (17) which is present on the substrate surface (10s), the liquid (19) which has been applied to the substrate surface (10s) being heated by a heating area (6u, 6u', 6u", 6u"', 6u^{IV}, 6u^{V}) which is located above and/or below the substrate surface (10s), wherein the temperature T_{R} of the liquid (19) is kept constant by moving the heating area (6u, 6u', 6u", 6u"', 6u^{IV}, 6u^{V}) up and down, wherein the substrate (10) forms a base for the applied liquid (19) and a border (4s) of a substrate holder prevents the liquid (19) from draining, **characterized in that** the border (4s) forms with the substrate (10) a trough for accommodating the liquid (19) during the treatment.

2. The method as claimed in Claim 1, wherein the heating area temperature T_{H} of the heating area (6u, 6u', 6u", 6u'", 6u^{IV} 6u^{V}) is kept constant at least during treatment, especially in addition during a changing of the substrate (10) which is to be cleaned and/or during a preheating phase,

3. The method as claimed in one of Claims 1 or 2, wherein the heating area (6u, 6u', 6u", 6u"', 6u^{IV}, 6u^{V}) is located parallel to the substrate surface (10s) during the treatment.

4. The method as claimed in at least one of the preceding claims, wherein the substrate (10) with its back (10r) which faces away from the substrate surface (10s) is held by an especially rotatable substrate holder (4).

5. The method as claimed in at least one of the preceding claims, wherein the heating area (6u, 6u', 6u", 6u"', 6u^{IV}, 6u^{V}) has a minimum distance of 1 mm, especially 10 mm, preferably 25 mm, still more preferably 50 mm, still more preferably 100 mm.

6. The method as claimed in at least one of the preceding claims, wherein the temperature T_{R} is kept constant, especially solely by control/adjustment of the movement of the heating area (6u, 6u', 6u", 6u"', 6u^{IV}, 6u^{V}) up and down, especially with a deviation from the temperature T_{R} of less than 5°C, preferably less than 1°C, still more preferably less than 0.1°C, still more preferably less than 0.001°C.

7. The method as claimed in at least one of the preceding claims, wherein the temperature T_{R} and/or the heating area temperature T_{H} is measured at least during treatment, especially by at least one temperature sensor (15) which is attached preferably to the heating area (6u, 6u', 6u", 6u'", 6u^{IV}, 6u^{V}).

8. A device for treatment of a substrate surface (10s) of a substrate (10) by applying a liquid (19) to the substrate surface (10s) or to a layer (17) which is present on the substrate surface (10s), with the following:
- a heating area (6u, 6u', 6u", 6u"', 6u^{IV}, 6u^{V}) which is located above and/or below the substrate surface (10s) for heating of the liquid (19) which has been applied to the substrate surface (10s),
- means for moving the heating area (6u, 6u', 6u", 6u"', 6u^{IV}, 6u^{V}) up and down and keeping the temperature T_{R} of the liquid (19) constant, **characterized in that** the device is formed such that the fluid (19) applied to the substrate (10) can be prevented from draining by a border (4s) of a substrate holder (4), wherein a base for the liquid (19) can be formed by the substrate (10) and the border (4s) with the substrate (10) can form a trough for accommodating the liquid.

9. The device as claimed in Claim 8 with the especially rotatable substrate holder (4) for holding the substrate (10) with its back (10r) facing away from the substrate surface (10s).

10. The device as claimed in Claim 8 or 9 with at least one temperature sensor, which is preferably attached to the heating area (6u, 6u', 6u", 6u"', 6u^{IV}, 6u^{V}) for measuring the temperature T_{R} and/or the heating area temperature T_{H.}

## Revendications

1. Procédé de traitement d'une surface (10s) d'un substrat (10) par application d'un liquide (19) sur la surface (10s) de substrat ou sur une couche (17) présente sur la surface (10s) de substrat, dans lequel le liquide (19) appliqué sur la surface (10s) de substrat est chauffé par une surface chaude (6u, 6u', 6u", 6u"', 6u^{IV}, 6u^{V}) disposée au-dessus et/ou en-dessous de la surface (10s) de substrat, dans lequel une température T_{R} du liquide (19) est maintenue constante en tamponnant ou en éloignant la surface chaude (6u, 6u', 6u", 6u"', 6u^{IV}, 6u^{V}), dans lequel le substrat (10) forme un fond pour le liquide (19) appliqué et une bordure (4s) d'un support de substrat (4) empêche que le liquide (19) ne s'écoule, **caractérisé en ce que** la bordure (4s) forme avec le substrat (10) une cuve pour recevoir le liquide (19) pendant le traitement.

2. Procédé selon la revendication 1, dans lequel une température de chauffage T_{H} de la surface chaude (6u, 6u', 6u", 6u"', 6u^{IV}, 6u^{V}) est maintenue constante, au moins pendant le traitement, en particulier en plus pendant un changement du substrat (10) à nettoyer et/ou pendant une phase de pré-chauffage.

3. Procédé selon la revendication 1 ou 2, dans lequel la surface chaude (6u, 6u', 6u", 6u"', 6u^{IV}, 6u^{V}) est disposée parallèlement à la surface (10s) de substrat pendant le traitement.

4. Procédé selon au moins l'une des revendications précédentes, dans lequel le substrat (10) est maintenu par le support de substrat (4), en particulier rotatif, par son dos (10r) détourné de la surface (10s) de substrat.

5. Procédé selon au moins l'une des revendications précédentes, dans lequel la surface chaude (6u, 6u', 6u", 6u"', 6u^{IV}, 6u^{V}) présente une distance minimale de 1mm, en particulier de 10 mm, de préférence de 25 mm, plus encore de préférence de 50 mm, plus encore de préférence de 100 mm.

6. Procédé selon au moins l'une des revendications précédentes, dans lequel la température T_{R}, est maintenue constante, en particulier exclusivement, par commande/réglage du tamponnage et de l'éloignement de la surface chaude (6u, 6u', 6u", 6u"', 6u^{IV}, 6u^{v}), en particulier avec un écart de la température T_{R} inférieur à 5°C, de préférence inférieur à 1°C, plus encore de préférence inférieur à 0,1°C, plus encore de préférence inférieur à 0,001°C.

7. Procédé selon au moins l'une des revendications précédentes, dans lequel la température T_{R} et/ou la température de chauffage T_{H} est mesurée au moins pendant le traitement, en particulier par au moins un capteur de température (15) appliqué de préférence sur la surface chaude (6u, 6u', 6u", 6u'", 6u^{IV}, 6u^{V}).

8. Dispositif de traitement d'une surface (10s) d'un substrat (10) par application d'un liquide (19) sur la surface (10s) de substrat ou sur une couche (17) présente sur la surface (10s) de substrat, comprenant:
- une surface chaude (6u, 6u', 6u", 6u"', 6u^{IV}, 6u^{V}) disposée au-dessus et/ou en-dessous de la surface (10s) de substrat pour chauffer le liquide (19) appliqué sur la surface (10s) de substrat, des moyens pour tamponner et éloigner la surface chaude (6u, 6u', 6u", 6u"', 6u^{IV}, 6u^{V}) et maintenir constante une température T_{R} du liquide (19)
- **caractérisé en ce que** le dispositif est ainsi conçu qu'une bordure (4s) d'un support de substrat (4) empêche que le liquide (19) appliqué sur le substrat (10) ne s'écoule, dans lequel un fond pour le liquide (19) peut être formé avec le substrat (10) et la bordure (4s) forme avec le substrat (10) une cuve pour recevoir le liquide (19).

9. Dispositif selon la revendication 8. avec le support de substrat (4), en particulier rotatif, pour recevoir le substrat (10) par son dos (10r) de la surface (10s) de substrat.

10. Dispositif selon la revendication 8 ou 9, avec au moins un capteur de température pour mesurer la température T_{R} et/ou la température de chauffage T_{H}, disposé de préférence sur la surface chaude (6u, 6u', 6u", 6u"', 6u^{IV}, 6u^{V}).
